# DEMANDE DE BREVET EUROPEEN

(11) **EP 2 733 730 A2**
(43) Date de publication de la demande: **21.05.2014**
(21) Numéro de dépôt: 13191670.2
(22) Date de dépôt: 05.11.2013
(51) Int. Cl.: H01L 21/66, G01N 1/28

(54) **Procédé de préparation d'un échantillon en pointe pour analyse en sonde tomographique de structures électroniques**

(30) Priorité: 12.11.2012 FR 1260709
(71) Demandeur: COMMISSARIAT A L'ENERGIE ATOMIQUE ET AUX ENERGIES ALTERNATIVES, 75015 Paris (FR); Centre National de la Recherche Scientifique, 75016 Paris (FR)
(72) Inventeur: Grenier, Adeline, 38000 Grenoble (FR); Barnes, Jean-Paul, 38500 Voiron (FR); Duguay, Sébastien, 76800 Saint Etienne du Rouvray (FR)
(74) Mandataire: Desvignes, Agnès

(57) **Abrégé**

Afin de permettre l'analyse atomique complète en sonde tomographique de structures tridimensionnelles présentant au moins une couche conductrice ou semi-conductrice Iᵣₒᵢ sur une couche d'isolant BOX, on réalise au moins un dépôt en couche mince d'un matériau isolant sur la surface extérieure de l'échantillon, localisé à hauteur de la structure à analyser ROI, sous forme d'une ou plusieurs bandes i1, i2 s'étendant sur toute la hauteur de la couche isolante jusqu'à une région à hauteur du substrat support Bulk-Si, formant un lien de matériau isolant reliant mécaniquement le substrat support, la couche isolante et la structure à analyser.

## Description

### DOMAINE TECHNIQUE

La présente invention concerne un procédé de préparation d'un échantillon pour analyse en sonde atomique tomographique. La sonde atomique tomographique est un microscope tridimensionnel analytique haute résolution. Il existe de nombreuses configurations instrumentales relevant de cette technique d'analyse. On en trouve des descriptions dans l'ouvrage "Atom probe field ion microscopy" de Miller et al publié en 1996 par Clarendon Press/Oxford.

Cette technique d'analyse à l'échelle atomique est notamment utilisée dans le domaine des matériaux semi-conducteurs, généralement dans une configuration dans laquelle la sonde atomique tomographique est assistée par laser. L'échantillon à analyser est en pratique placé dans une chambre à ultravide, encore appelée chambre de vol. Cet échantillon aura été préalablement préparé et formé par usinage (abrasion) par faisceau d'ions en une pointe très fine, avec un rayon de courbure à l'apex inférieur à 50 nanomètres. En appliquant une tension de quelques kilovolts à cette pointe, un champ électrique pouvant dépasser la dizaine de volts/nanomètre est engendré à l'apex de la pointe. Celle-ci est ensuite illuminée par des impulsions lasers femto-secondes focalisées qui permettent d'arracher les atomes de la surface de la pointe. Les atomes sont évaporés sous forme d'ions, qui sont ensuite recueillis par un détecteur de grande sensibilité résolu en temps et en position. Le détecteur est typiquement situé à plusieurs dizaines de centimètres de la pointe, à l'intérieur de la chambre de vol. Pour chaque ion recueilli par le détecteur, la mesure du temps de vol entre la pointe et le détecteur permet de déterminer la nature chimique de l'ion ; la sonde atomique est donc dans un premier temps un spectromètre de masse à temps de vol. Les coordonnées de l'impact de l'ion dans le plan du détecteur permettent ensuite de déterminer par projection inverse la position initiale de l'ion à la surface de la pointe. A chaque atome détecté est associé un incrément en profondeur lié à sa nature chimique, ce qui permet au final de reconstruire l'échantillon analysé en trois dimensions à l'échelle quasi-atomique.

La sonde atomique est une technique d'analyse destructrice. C'est un instrument puissant qui permet de caractériser et comprendre ce qui se passe dans les structures nanométriques et d'améliorer les technologies de fabrication associées.

### ETAT DE L'ART

Suivant l'état de l'art, la préparation de l'échantillon pour analyse en sonde tomographique est réalisée en plaçant la structure dans la chambre à vide d'un appareil de micro-usinage dit "MEB-FIB", ou FIB à double faisceaux ("*FIB dual beam*") qui comprend une colonne d'ions focalisés (FIB c'est-à-dire "*Focused Ion Beam*"), ou colonne ionique et un microscope électronique à balayage MEB monté en angle avec la colonne ionique. C'est donc une machine combinant un faisceau électronique et faisceau d'ions focalisés, qui permet de faire à la fois du micro-usinage et de l'imagerie, et donc d'associer l'imagerie électronique fournie par le MEB comme aide aux étapes de micro-fabrication réalisées par le FIB.

La colonne ionique FIB permet de manière connue d'effectuer notamment un usinage de surface suivant un patron pré-établi, par pulvérisation des atomes de la surface exposée, par projection d'un faisceau d'ions focalisés, typiquement des ions de gallium (Ga⁺). Le FIB permet aussi d'effectuer des dépôts chimiques en phase vapeur, par utilisation de l'énergie du faisceau combinée à l'injection d'un gaz précurseur. On réalise ainsi notamment des dépôts de tungstène (par injection d'hexacarbonyle de tungstène), ou d'oxyde, par exemple d'oxyde de silicium SiOx (par injection Tetra-Ethyl-Ortho-Silicate, ou plus simplement tetraethoxysilane, connu sous l'acronyme TEOS).

La préparation d'un échantillon en vue d'une analyse en sonde atomique tomographique utilise un tel appareil. L'échantillon y est préparé de la façon suivante :
- la structure à analyser (échantillon) est placée dans la chambre à vide.
- une région d'intérêt est précisément repérée par imagerie électronique.
- une couche de protection est déposée en surface de cette région d'intérêt, typiquement une couche de tungstène ou de platine. Par exemple une couche de protection en tungstène sera obtenue de la façon suivante : on introduit une tête d'injection d'un gaz précurseur, dans l'exemple de l'hexacarbonyle de tungstène, dans la chambre à vide. Le gaz est adsorbé par l'échantillon. On balaye la zone de dépôt sur l'échantillon à travers une fenêtre de dépôt, avec le faisceau d'ions, ce qui entraîne la décomposition du gaz précurseur. Dans cette opération, le tungstène non volatile reste déposé à la surface de l'échantillon dans la zone souhaitée.
- on procède à un usinage automatique (piloté par logiciel) pour dégager le volume de la région d'intérêt, typiquement par réalisation d'une pluralité de trous ou tranchées autour de la région d'intérêt; puis on prélève le volume désiré à l'aide de la pointe d'un micromanipulateur et on fixe ce volume par soudure sur un porte-échantillon, généralement en tungstène;
- enfin, on usine ce volume en forme de pointe de forme sensiblement ogivale, par amincissement annulaire progressif par faisceau d'ions focalisés.

Dans l'invention, on s'intéresse plus particulièrement à l'analyse en sonde tomographique d'échantillons de structures électroniques dites 3D, en technologie silicium sur isolant ou SOI (acronyme anglo-saxon de "*Silicon on Insulator*"). Par exemple la publication Elsevier Ultramicroscopy, volume 11, issue 6, May 2011, Pages 530-534, Atom probe analysis of a 3D finFET with high-k metal gate de M. Gilbert, W. Vandervorst, S. Koelling et A.K. Kambham, rapporte l'analyse en sonde tomographique de l'empilement de grille d'un exemple de structure de transistor tridimensionnel, dans l'exemple un transistor dit finFET *("Fin-Shaped Field Effect Transistor*"). Les transistors tridimensionnels, tels les transistors connus dans la littérature technique sous les termes "FINFET", "DUALGATE", "TRIGATE",...etc, ont une structure grille, source, drain qui se développe dans les trois dimensions.

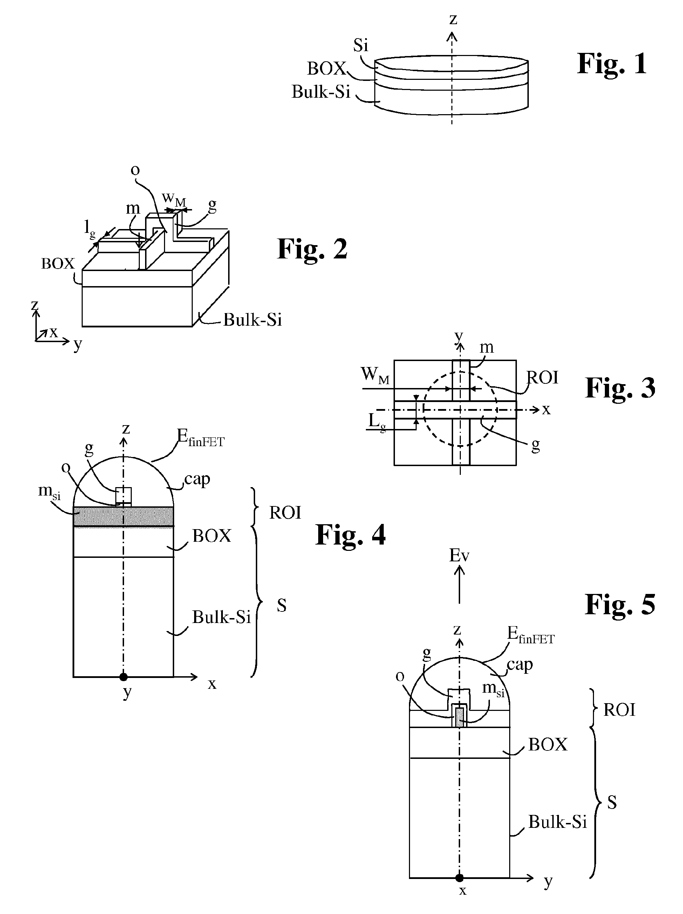

Brièvement et pour mémoire, les structures électroniques sur substrat SOI sont élaborées à partir d'une plaquette de silicium sur isolant, schématiquement représentée sur la figure 1, formée d'un empilement d'une couche de silicium Si qui peut aller d'une dizaine de nanomètres à quelques micromètres d'épaisseur, sur une couche de support isolant, par exemple du dioxyde de silicium (SiO₂), formée sur un substrat support, en général de silicium. Dans la littérature technique, la couche de support isolant et la couche de substrat support silicium (ou substrat de silicium massif) sont généralement respectivement désignées par les expressions "BOX" ("*buried oxide"*-littéralement oxyde enterré) et "Bulk-Si".

Une telle structure à analyser en sonde tomographique comprend nécessairement la couche substrat support et la couche d'isolant du substrat SOI. Au dessus de la couche d'isolant "BOX", en fonction de la géométrie 3D de la structure, on peut avoir selon le lieu d'observation, zéro, une ou plusieurs couches minces ou ultra-minces de matériaux. On entend ici par couches minces, des couches transparentes aux électrons, permettant leur observation par microscope électronique en transmission (MET). Typiquement, les couches minces ont des épaisseurs de 100 nanomètres et moins, et les couches ultraminces, des épaisseurs de 50 nanomètres et moins.

On prend l'exemple d'une structure de transistor tridimensionnel très schématiquement illustrée sur les vues simplifiées en perspective de la figure 2 et de dessus de la figure 3, dans un repère x, y, z ou l'axe z est l'axe d'empilement des couches de substrat et structure. La partie active source/drain est réalisée par gravure de la couche de silicium du substrat SOI en forme d'une mesa de largeur W_{M}. Dans l'exemple, la mesa mₛᵢ s'étend longitudinalement suivant l'axe x. La ligne de commande ou grille g de largeur L_{g}, en matériau conducteur, par exemple du silicium polycristallin, s'étend suivant l'axe y perpendiculairement à la mesa. De part et d'autre de la mesa, elle est formée sur la couche d'isolant BOX du substrat. Au niveau de la mesa, elle prend une forme en pont, avec une grille supérieure et deux grilles latérales encadrant la mesa et pouvant être isolées de la mésa par une couche d'oxyde o, comme illustré. Par exemple, la couche d'oxyde a une épaisseur de 50 nanomètres entre le dessus de la mesa et la grille supérieure, et une épaisseur de 1,5 nanomètre (mais pouvant même être nulle) entre chacune des faces latérales longitudinales de la mesa et les deux grilles latérales. Dans d'autres exemples, il n'y a pas d'oxyde. Le canal ou "body" du transistor est défini par le volume de mesa mₛᵢ encadré par cette grille g. Ce canal est de longueur L_{g} (correspondant à la largeur de grille), de largeur W_{M} (correspondant à la largeur de la mesa) et de hauteur tₛᵢ (correspondant à l'épaisseur de la mesa). Les parties de la mesa qui débordent orthogonalement de part et d'autre de la grille forment la source et le drain du transistor.

Dans cet exemple, si on considère comme structure à analyser en sonde atomique tomographique, la zone notée "ROI" sur la figure 3, centrée sur le canal du transistor, suivant le lieu "géographique" observé, on a zéro, une ou plusieurs couches de structure au-dessus de la couche isolante BOX du substrat SOI. Ceci ressort clairement de la figure 1 et des figures 4 et 5 représentant schématiquement des vues en coupe axiale d'un échantillon correspondant E_{finFET} formé en pointe. La figure 4 représente la coupe axiale relativement au plan zx, et la figure 5 la coupe axiale relativement au plan zy.

L'échantillon E_{finFET} est globalement en forme de cylindre d'axe z, se terminant en pointe sensiblement de forme ogivale. Il comprend à la base, le substrat S constitué de la couche de support silicium Bulk-Si et la couche isolante BOX et dans la pointe, la structure ROI de la figure 3. Cette structure est recouverte d'une couche de protection cap.

La topographie des couches de cet échantillon est la suivante :
A l'endroit du canal du transistor, on a un empilement de trois couches sur la couche isolante BOX : mesa silicium mₛᵢ, oxyde o et grille g.

En dehors du canal, mais au niveau de la mesa m, on a une seule couche sur la couche isolante BOX : la mesa silicium mₛᵢ.

En dehors de la mesa silicium mₛᵢ, mais sous la ligne de grille g, on trouve au-dessus de la couche de support isolante BOX :
- l'empilement de la couche d'oxyde o et de la couche de grille g, à proximité immédiate des flancs du canal, et
- seulement la couche de grille au-delà.

Ailleurs, on ne trouve que la couche de protection cap au-dessus de la couche de support isolante BOX.

L'analyse en sonde atomique tomographique de l'échantillon E_{finFET} doit permettre d'évaporer par la pointe, chacun des atomes du volume entier de la région d'intérêt, avec un champ d'évaporation Ev, dont la valeur varie au fur et à mesure de l'évaporation, en fonction du matériau à évaporer. On entend par volume entier de la région d'intérêt, le volume de la structure mais aussi le volume du substrat S. La structure du substrat influence en effet physiquement la structure électronique réalisée dessus. Il est donc essentiel d'obtenir l'évaporation complète des atomes de toutes les couches y compris celles du substrat pour permettre de détecter d'éventuels défauts ainsi que comprendre les influences et interactions diverses des matériaux et étapes de fabrication de ces structures. En d'autres termes, il est essentiel de conduire l'analyse atomique de l'échantillon en sonde tomographique depuis la toute première couche de la région d'intérêt, évaporée en premier, jusqu'à la dernière couche du substrat, la couche Bulk-Si dans l'exemple illustré, évaporée en dernier. Cela veut dire évaporer les matériaux dans leur ordre d'apparition au sommet de la pointe au fur et à mesure de l'évaporation. On applique pour cela un couple potentiel électrique, énergie laser approprié, permettant l'évaporation des matériaux contenus dans la pointe.

Si on reprend l'exemple de la structure illustrée à la figure 3 et les vues en coupe axiale des figures 4 et 5 de l'échantillon E_{finFET}, il s'agit d'évaporer d'abord le matériau de la couche de protection cap, puis le matériau de grille g, l'oxyde de grille o et le silicium de la mesa m dans leur ordre d'apparition à la pointe au fur et à mesure de l'évaporation ionique, puis également l'isolant de la couche isolante BOX et enfin le silicium du substrat support, en appliquant le champ électrique d'évaporation approprié.

Or dans la pratique, on constate que l'échantillon casse systématiquement à l'interface avec la couche d'isolant BOX du substrat.

On explique cette rupture par la grande différence de champs d'évaporation qui peut exister en fonction des matériaux constituants la structure à analyser et l'accumulation de charges électriques locales à l'interface avec la couche isolante BOX. Le champ électrique nécessaire à l'évaporation de la couche d'isolant est en effet au moins deux fois supérieur à celui nécessaire à l'évaporation d'une couche de silicium (de l'ordre de 33 volts par nanomètre).

La publication de Elsevier, Ultramicroscopy 109 pp 486-491 (2009), "Failure mechanisms of silicon-based atom-probe tips" par S. Kolling, W.Vandervorst rapporte l'observation de différents types de cassure ou d'altération des échantillons de structures sur silicium, pendant l'analyse tomographique. Cette publication décrit des voies d'optimisation, qui comprennent différentes propositions pour empêcher la formation d'oxyde natif par oxydation de la surface de l'échantillon durant les étapes de préparation de l'échantillon, et notamment les étapes d'usinage, car l'oxyde natif serait à l'origine de cassures de l'échantillon par un effet d'accumulation de charges électriques positives. Mais ces différentes propositions ne fournissent pas de solutions pour le problème de cassure de l'échantillon à l'interface avec la couche d'oxyde isolante du substrat SOI supportant la structure à analyser.

Or cette rupture systématique à l'interface de la couche de support isolante du substrat est très gênante car elle empêche de caractériser complètement la structure : l'analyse atomique n'atteint jamais le substrat, alors que sa constitution influe sur la structure électronique réalisée dessus.

Ainsi, les résultats d'analyse de sonde atomique tomographique que l'on peut trouver dans les publications sur le sujet, ne montrent que des reconstructions du volume 3D des structures électroniques, comme on peut le voir dans la première publication citée pour l'analyse de transistors tridimensionnels, mais pas de leurs substrats.

### RESUME DE L'INVENTION

Dans l'invention, on a cherché une solution à ce problème technique de rupture des échantillons à hauteur de la couche de support isolant de substrat, afin de permettre l'analyse atomique complète en sonde tomographique de structures tridimensionnelles sur substrat SOI.

La solution technique apportée à ce problème technique réside dans la réalisation d'au moins un dépôt en couche mince d'un matériau isolant sur la surface extérieure de l'échantillon, à hauteur de la structure à analyser, sous forme d'une ou plusieurs bandes s'étendant chacune depuis une région à hauteur de la couche de substrat support, sur toute la hauteur de la couche isolante et formant un lien de matériau isolant reliant mécaniquement la couche de substrat support, la couche isolante et la structure à analyser. Le matériau isolant est un matériau dont la valeur du champ d'évaporation du matériau isolant à déposer doit être proche de la moyenne des champs d'évaporation des autres matériaux constituant la structure à analyser.

Telle que revendiquée, l'invention concerne ainsi un procédé de préparation d'un échantillon formé en pointe pour une analyse atomique en sonde tomographique d'une structure située dans le volume de la pointe, la structure à analyser étant disposée sur un substrat et recouverte d'une couche de protection, le substrat comportant au moins une couche support en matériau conducteur ou semi-conducteur et la structure à analyser comprenant au moins une couche conductrice ou semi-conductrice disposée sur une couche isolante, le procédé étant **caractérisé en ce qu'il** comprend au moins un dépôt en couche mince d'un matériau isolant localisé sur la surface extérieure de l'échantillon, à hauteur de la structure à analyser et s'étendant sur toute la hauteur de ladite couche isolante jusqu'à une région à hauteur du substrat support, formant un lien de matériau isolant reliant mécaniquement le substrat support, la couche isolante et la structure à analyser, ledit matériau isolant déposé en couche mince étant un matériau dont la valeur du champ d'évaporation est égale ou voisine de la moyenne des champs d'évaporation des matériaux constituant la structure à analyser.

Selon un aspect de l'invention, ledit matériau X est choisi parmi les matériaux suivants : oxyde de silicium, de zirconium ou de hafnium.

Selon un autre aspect de l'invention, la couche support du substrat est en silicium, la couche isolante est en oxyde de silicium, et le matériau isolant est un oxyde de silicium.

Selon un aspect de l'invention le ou les dépôts de matériau isolant sont réalisés dans un appareil d'usinage de l'échantillon, après cet usinage.

D'autres avantages et caractéristiques de l'invention sont présentés dans la description détaillée qui suit et dans les dessins annexés dans lesquels:
- la figure 1 est une vue schématique d'une plaquette de substrat SOI à partir de laquelle sont fabriquées des structures tridimensionnelles, montrant l'empilement suivant un axe z des couches de substrat support silicium, support isolant et silicium;
- la figure 2 est une vue schématique en perspective d'un transistor tridimensionnel sur substrat SOI ;
- la figure 3 est une vue de dessus d'un tel transistor, montrant en transparence les éléments grille et mesa silicium et une région d'intérêt autour de ces éléments pour analyse atomique en sonde tomographique;
- la figure 4 est une vue schématique en coupe axiale suivant l'axe z d'empilement des couches et l'axe longitudinal x de mesa silicium de ce transistor;
- la figure 5 est une vue schématique en coupe axiale suivant l'axe z d'empilement des couches et l'axe longitudinal y de la grille d'un tel transistor;

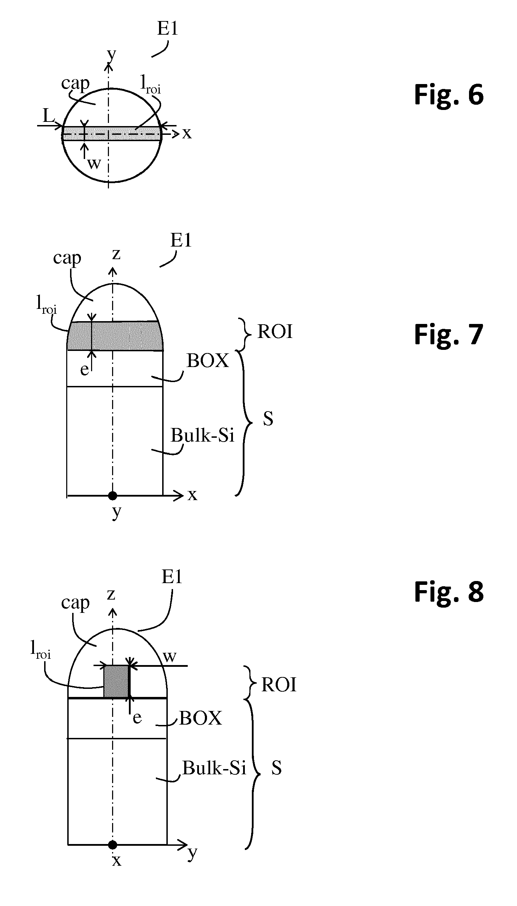

- la figure 6 est une vue en coupe transversale dans le plan défini par les axes x et y, d'une structure simple à analyser formée sur un substrat SOI;
- les figures 7 et 8 sont des vues en coupe axiale respectivement dans le plan défini par les axes x et z, et y et z, d'un échantillon d'une telle structure, après les étapes de recouvrement par une couche de protection et usinage en pointe;

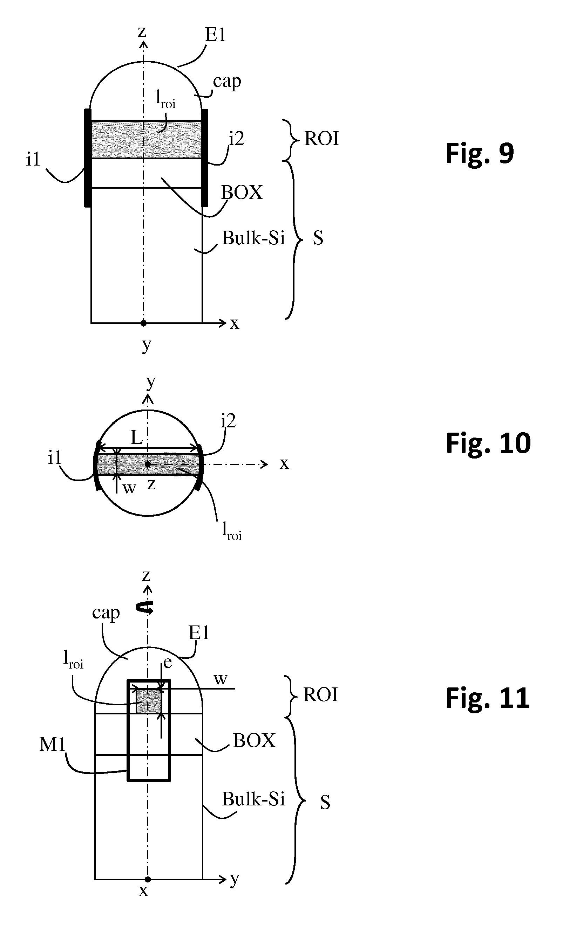

- la figure 9 est une vue en coupe axiale de l'échantillon après dépôt de matériau isolant en surface de l'échantillon, à hauteur de chaque face d'extrémité du barreau selon l'invention;
- la figure 10 est une vue en coupe transversale correspondante;
- la figure 11 illustre une étape de dépôt de matériau isolant correspondante, réalisée in situ dans un appareil de préparation en pointe de l'échantillon, à travers une fenêtre de balayage cadrée sur une face d'extrémité du barreau;

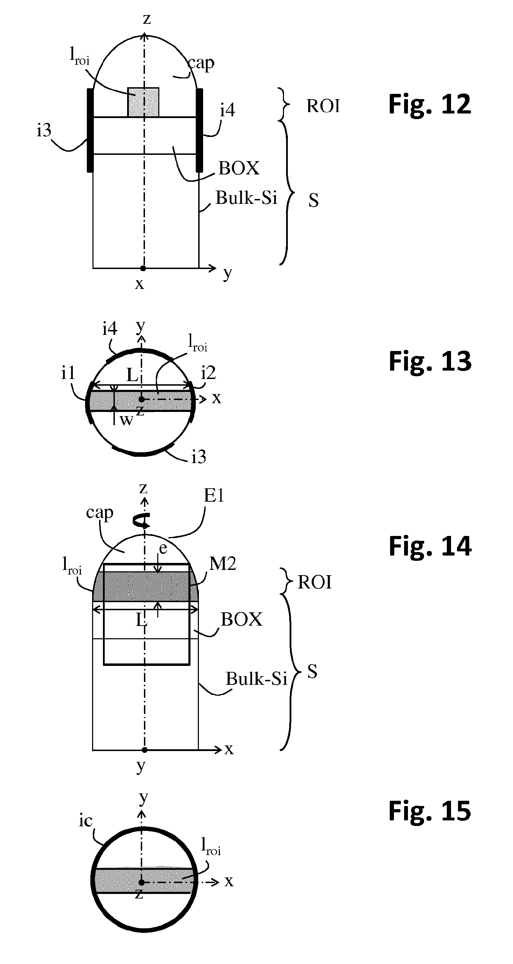

- la figure 12 est une vue en coupe axiale de l'échantillon, dans le plan défini par les axes z et y, après dépôt de matériau isolant en surface de l'échantillon, à hauteur des faces latérales longitudinales du barreau;
- la figure 13 est une vue en coupe transversale correspondante;
- la figure 14 illustre une étape de dépôt de matériau isolant correspondante, réalisée in situ dans l'appareil de préparation en pointe de l'échantillon, à travers une fenêtre de balayage cadrée sur une face latérale longitudinale du barreau;
- la figure 15 est un diagramme illustrant la séquence des étapes de dépôt de matériau isolant en surface de l'échantillon mises en oeuvre in situ, dans l'appareil de préparation en pointe de l'échantillon, pour obtenir l'échantillon illustré sur la figure 13; et

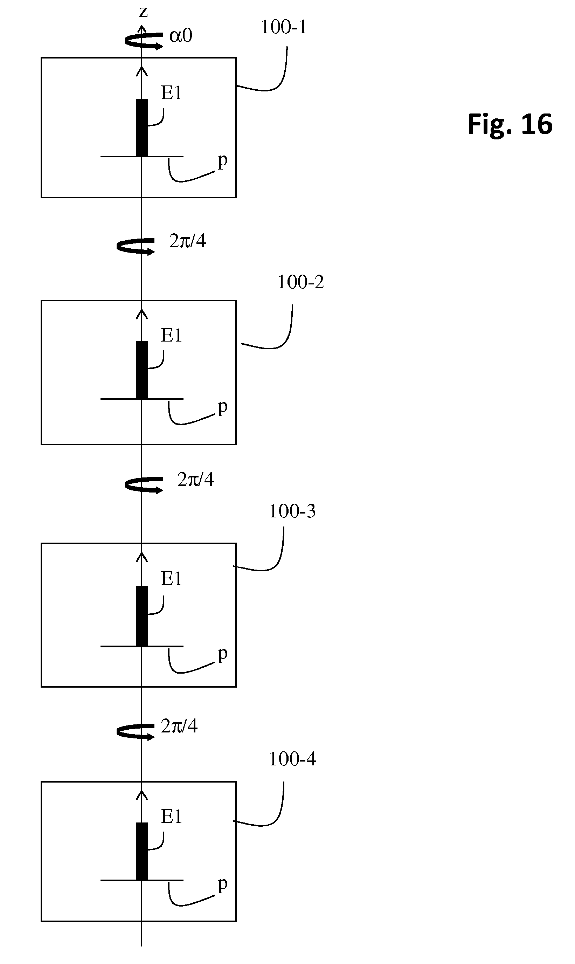

- la figure 16 illustre en vue de dessus, une variante de l'invention, selon laquelle un dépôt de matériau isolant est réalisé sur toute la surface externe de l'échantillon, par une étape de dépôt réalisée ex situ, en dehors de l'appareil de préparation en pointe de l'échantillon.

### DESCRIPTION DETAILLEE

L'invention propose une préparation de l'échantillon qui permet lors de l'analyse en sonde atomique tomographique, de traverser l'interface structure/substrat SOI, sans rupture de la pointe à cette interface. On obtient ainsi une analyse complète d'un "objet" électronique formé sur un substrat SOI, y compris ce substrat SOI.

L'invention va être plus particulièrement expliquée en prenant en exemple comme structure ROI à analyser formée sur un substrat SOI, une couche Iᵣₒᵢ d'un matériau conducteur ou semi-conducteur disposée sur une couche isolante qui est la couche d'isolant BOX du substrat, et formée en un barreau rectangulaire de longueur L suivant l'axe x, d'épaisseur e suivant l'axe z et de largeur w suivant l'axe y.

Un échantillon correspondant E1, préparé pour analyse atomique en sonde tomographique, typiquement dans un appareil MEB FIB, est illustré sur les figures 6 à 8. L'échantillon E1 est, de manière habituelle, globalement en forme de cylindre d'axe z, se terminant en pointe sensiblement de forme ogivale. Le corps du cylindre est formé par un substrat S constitué de la couche de support silicium Bulk-Si et de la couche isolante BOX. La structure à analyser, notée ROI, est située à l'intérieur du volume de la pointe de l'échantillon. Elle comprend dans l'exemple la couche conductrice ou semi-conductrice formée en un barreau Iᵣₒᵢ sur la couche isolante BOX. Cette structure est recouverte par une couche de protection cap, prévue pour protéger la structure pendant l'étape d'usinage en pointe de l'échantillon.

Selon l'invention, on prévoit un dépôt localisé de matériau isolant en surface de l'échantillon E1, à hauteur de la structure ROI, et qui s'étend depuis cette structure jusqu'à la couche de substrat support Bulk-SI du substrat S. Ce dépôt de matériau isolant forme un lien mécanique entre la couche substrat support Bulk-Si, la couche isolante BOX et la couche conductrice ou semi-conductrice Iᵣₒᵢ de la structure à analyser.

Ce dépôt à hauteur de la structure se traduit dans l'exemple par la formation en surface de l'échantillon E1 de deux bandes de matériau isolant i1 et i2, disposées symétriquement par rapport à l'axe x, à hauteur de la structure et s'étendant jusqu'à la couche de substrat support Bulk-Si, comme illustré sur les figures 9 et 10.

Chaque bande forme ainsi un lien de matériau isolant reliant mécaniquement les deux couches Bulk-Si et BOX du substrat et la structure à analyser. Cette consolidation mécanique permet d'éviter la rupture de la pointe à cette interface pendant l'évaporation ionique des atomes constituant les matériaux au-dessus de cette interface.

Plus précisément, dans l'exemple illustré, chacune des bandes i1 et i2 est en contact avec (ou recouvre directement) les surfaces de coupe:
- de la structure ROI, par la face d'extrémité du barreau Iᵣₒᵢ, et
- des couches de support isolant BOX et de substrat support Bulk-Si.

On entend par surface de coupe, la surface de ces couches qui affleurent à la surface extérieure de l'échantillon. Ces surfaces de coupe sont celles dégagées par l'usinage, lors de la préparation de l'échantillon.

Le matériau isolant est un matériau dont la valeur du champ d'évaporation est égale ou voisine, à plus ou moins 10 pour cent, de la moyenne des champs d'évaporation des matériaux constituant la structure à analyser. En amenant un tel matériau isolant à hauteur des matériaux de la structure, comme on peut clairement le voir sur la figure 9, on évite le passage abrupt d'un matériau à un autre, donc un saut de champ d'évaporation, et donc de tension appliquée à la pointe.

Les deux effets mécanique et électrique se combinent ainsi avantageusement pour empêcher la cassure de l'échantillon à l'interface de la structure à analyser avec la couche d'isolant BOX.

En pratique, les bandes i1 et i2 de matériau isolant peuvent être avantageusement réalisées in situ, dans le même appareil que celui utilisé pour le prélèvement, le montage sur un porte-échantillon et le recouvrement de la structure par une couche de protection cap et pour l'usinage annulaire en pointe, à savoir typiquement un appareil à colonne d'ions focalisé avec un microscope à balayage électronique monté en angle, dit MEB FIB. On optimise ainsi les coûts de préparation des échantillons et on contrôle précisément par imagerie électronique, l'épaisseur du dépôt d'isolant, qui doit être un dépôt couche mince, pour ne pas augmenter de manière trop significative le diamètre de la pointe, ce qui empêcherait son analyse en sonde atomique tomographique. En pratique, cette condition correspond à un maintien d'un contraste suffisant, permettant de voir par transparence le substrat SOI et la structure à analyser en microscopie électronique à balayage. En pratique, on contrôle l'épaisseur du dépôt en observant ce contraste. Quand il est trop diminué, on arrête le dépôt.

On a pu déterminer que l'épaisseur du dépôt d'isolant à réaliser selon l'invention est d'environ 2 à 3 nanomètres.

Dans un tel appareil MEB-FIB, ces bandes seront en pratique réalisées comme suit, après l'étape d'usinage en pointe de l'échantillon:

On introduit le gaz précurseur par la tête d'injection de l'appareil et on commande par logiciel un balayage du faisceau électronique de la colonne MEB, dans une fenêtre de balayage M1, qui délimite la zone de dépôt en surface de l'échantillon, pendant une durée contrôlée par microscope électronique à balayage, par observation du contraste entre le substrat SOI et la structure à analyser : les deux doivent rester visibles sur l'image fournie par le microscope.

Les dimensions de la fenêtre de balayage sont fonction de la géométrie de la structure à analyser.

Dans l'exemple, les dimensions de la fenêtre M1 sont déterminées de manière à d'une part au moins couvrir entièrement la face d'extrémité du barreau conducteur ou semi-conducteur qui affleure à la surface de l'échantillon E1 (surface de coupe du barreau Iᵣₒᵢ), ce qui délimite la largeur de la fenêtre qui doit être au moins aussi large que cette face, et le point le plus haut sur l'axe z et d'autre part atteindre une zone à hauteur de la couche substrat support, ce qui délimite le point le plus bas sur l'axe z.

Typiquement, on fait tourner l'échantillon, ou plus exactement, le porte-échantillon, autour de son axe z, jusqu'à obtenir l'alignement voulu de la face d'extrémité avec la tête d'injection. On peut aussi être amené à déplacer linéairement le porte-échantillon selon les 3 axes x, y et z, pour cadrer la fenêtre de dépôt relativement à cette face d'extrémité du barreau.

On réalise alors un premier dépôt, par exemple le dépôt correspondant à la bande i1 sur la figure 9. La réalisation de la deuxième bande i2, comprend à nouveau le positionnement de l'échantillon pour placer la zone déterminée de dépôt en surface, face à la tête d'injection. Typiquement, dans l'exemple, on fait tourner le porte-échantillon de 180 degrés (2π/2) par rapport à sa position précédente, pour placer l'autre face d'extrémité du barreau face à la tête d'injection. Puis on effectue le dépôt de la bande d'isolant i2, par balayage dans la même fenêtre M1.

L'invention ne se limite pas au mode de réalisation qui vient d'être décrit.

Les figures 12 à 14 illustrent un perfectionnement de l'invention selon lequel on réalise N bandes de matériau isolant, par N dépôts d'isolant successifs, après rotation de 2π/N de l'échantillon entre deux dépôts successifs. De cette façon, on homogénéise le dépôt de matériau isolant sur l'ensemble de la surface de l'échantillon contenant la structure à analyser améliorant ainsi les effets mécaniques et électriques sus-cités.

Dans l'exemple illustré, N=4. On a ainsi quatre bandes, les bandes i1 et i2 déjà décrites, auxquelles s'ajoutent les bandes i3 et i4. La multiplicité des bandes permet notamment d'améliorer le moyennage du champ électrique d'évaporation vu à l'interface avec la couche isolante BOX.

La séquence des dépôts est ainsi la suivante, en référence à la figure 14 illustrant les 4 bandes i1 à i4, aux figures 10 et 15 figurant les fenêtres de dépôt utilisées et à la figure 16, illustrant les différentes étapes de dépôt/placement de l'échantillon :
- étape 100-1 : rotation de α0, autour de l'axe z, pour amener la première zone de dépôt en surface de l'échantillon, correspondant à la réalisation de la bande i1, face à la tête d'injection. Cette opération est contrôlée par imagerie électronique ; puis dépôt dans une première fenêtre M1.
- étape 100-2 : rotation de 2π/4 (90°), autour de l'axe z, depuis la position précédente, pour amener la deuxième zone de dépôt en surface de l'échantillon, correspondant à la réalisation de la bande i3, face à la tête d'injection. Puis dépôt dans une deuxième fenêtre M2.
- étape 100-3 : rotation de 2π/4 autour de l'axe z, depuis la position précédente, pour amener la troisième zone de dépôt en surface de l'échantillon, correspondant à la réalisation de la bande i2, face à la tête d'injection. Puis dépôt dans la première fenêtre M1.
- étape 100-4 : rotation de 2π/4 autour de l'axe z, depuis la position précédente, pour amener la deuxième zone de dépôt en surface de l'échantillon, correspondant à la réalisation de la bande i4, face à la tête d'injection. Puis dépôt dans une deuxième fenêtre M2.

On a vu que les dimensions des fenêtres définissant les zones de dépôt sont en pratique fonction de la géométrie de la structure à analyser.

Dans l'exemple de la structure à analyser prise en exemple, à savoir une couche en forme de barreau Iᵣₒᵢ, la fenêtre M1 est définie pour que le dépôt à travers M1 couvre toute la surface *e* x *w* de chacune des faces d'extrémité du barreau. On bénéficie ainsi d'une surface d'ancrage direct des bandes i1 et i2 sur la structure, qui correspond à celle de la face d'extrémité du barreau. Cette accroche directe sur la structure améliore la fonction de résistance mécanique recherchée.

Dans cet exemple, ce sont les dimensions de la face d'extrémité du barreau qui définissent ainsi la largeur de cette fenêtre, supérieure, mais au moins égale, à la largeur e du barreau, ainsi que le point le plus haut suivant l'axe z de la fenêtre, pour recouvrir au moins toute la hauteur w de la face d'extrémité du barreau. Le point le plus bas sur l'axe z, définissant la hauteur de la fenêtre, est choisi pour couvrir toute l'épaisseur de la couche isolante BOX et une partie au moins de la couche de support Bulk-Si du substrat, comme illustré sur la figure 11.

On obtient ainsi un lien mécanique i1 ou i2 en contact, ancré, sur toute la surface des faces d'extrémité du barreau Iᵣₒᵢ, sur toute la hauteur de la couche isolante BOX, et sur une partie au moins de la hauteur de la couche de substrat support Bulk-Si.

S'agissant de la fenêtre M2, on note que dans la région à hauteur de la structure à analyser, les bandes i3 et i4 sont déposées à la surface de la couche de protection cap, comme on le voit clairement sur la figure 12. Elles ne sont pas en accroche directe avec la structure à analyser. La fonction de lien mécanique est moins forte, mais s'exerce sur toute la longueur du barreau.

La largeur de la fenêtre M2 et donc des bandes i3 et i4 correspond ici sensiblement à la longueur L du barreau Iᵣₒᵢ, en réalité un peu inférieure, pour adapter la forme rectangulaire du barreau à la forme en pointe dans la zone incluant la région d'intérêt. On a ainsi une présence de matériau isolant sur toute la hauteur et presque toute la longueur de la face latérale longitudinale du barreau.

On comprend que l'invention qui vient d'être décrite, dans deux exemples de mise en oeuvre, en relation avec une structure à analyser simple, limitée à un barreau de forme sensiblement rectangulaire, peut aussi s'appliquer à une structure plus complexe.

Elle peut s'appliquer à une structure bidimensionnelle pouvant être un empilement de couches isolantes et conductrices ou semi-conductrices déposées sur un substrat de silicium massif ou un substrat de silicium sur isolant.

Elle peut s'appliquer à une structure tridimensionnelle telle que celle par exemple, d'un transistor tridimensionnel tel qu'illustré sur la figure 2 (FINFET, DUALGATE, TRIGATE...etc). Dans ce cas, les largeurs des fenêtres seront adaptées en conséquence. Par exemple une fenêtre de dépôt sera définie, pour couvrir la surface des faces d'extrémité de la mésa silicium, en vue de réaliser deux bandes verticales chacune liant mécaniquement une face d'extrémité de la mesa silicium avec les surfaces de coupe de la couche de support isolante et de la couche de substrat support ; une autre fenêtre sera définie pour couvrir la surface des faces d'extrémité de la grille g, pour réaliser deux bandes verticales chacune liant mécaniquement une face d'extrémité de la grille avec les surfaces de coupe de la couche de support isolante et de la couche de substrat support. Dans les deux cas, les hauteurs des fenêtres seront choisies pour que les bandes d'isolant arrivent à hauteur du niveau le plus haut de la structure à analyser, donné dans l'exemple par la zone de grille au-dessus de la mesa.

Ainsi, les dimensions des fenêtres de dépôt rectangulaires sont adaptées en pratique à la géométrie de l'objet à analyser, selon qu'il est mono ou multicouches ; selon que l'on dispose de plus ou moins de couches conductrices ou semi-conductrices de la structure à analyser, qui affleurent en surface de l'échantillon.

Plus généralement, on peut selon le principe de l'invention réaliser ainsi N bandes, avec N étapes de dépôt successifs, et rotation de 2π/N de l'échantillon entre deux dépôts successifs. N entier.

N sera généralement un entier pair, pour bénéficier d'un effet de symétrie dans les effets mécanique et électriques, entre la pointe et le substrat.

La mise en oeuvre de l'invention dans un appareil MEB FIB comme il vient d'être décrit est avantageuse en ce sens que toute la phase de formation et préparation de l'échantillon pour analyse en sonde tomographique est réalisée in situ dans cet appareil. Les moyens de positionnement, en rotation notamment, sont des moyens prévus dans ces appareils. On peut ainsi facilement réaliser les différentes bandes d'isolant, tout autour de la région d'intérêt, en surface de l'échantillon.

On note à cet égard que les appareils MEB FIB sont généralement prévus avec tête d'injection de TEOS, permettant un dépôt d'isolant de type SiOx, proche de SiO2 (x différent mais proche de 2). L'étape de dépôt dure environ 5 secondes, et permet d'obtenir une épaisseur d'isolant (SiOx) entre 2 et 3 nanomètres. Cette épaisseur est en pratique contrôlée par imagerie électronique : le dépôt est arrêté lorsque le contraste entre le substrat SOI et la structure à analyser est fortement diminué.

Ces appareils sont donc spécialement adaptés à la mise en oeuvre de l'invention pour la préparation d'échantillons de structures électroniques formées sur un substrat silicium sur isolant SOI, spécialement sur isolant SiO2.

Mais une réalisation ex situ (c'est-à-dire hors MEB-FIB) du dépôt de matériau isolant selon l'invention peut aussi être envisagée lorsque l'on souhaite adapter le matériau isolant déposé à celui de la couche de support isolante. On peut ainsi déposer un isolant adapté au substrat SOI considéré, à analyser, comme par exemple du SiO2, du HfO2, du ZrO2, .... La liste n'étant pas exhaustive. Le dépôt est alors obtenu typiquement en plaçant la pointe sous atmosphère oxydante contrôlée pendant une durée déterminée, permettant d'obtenir le dépôt en couche mince souhaité. On obtient alors un dépôt d'isolant en couche mince, homogène qui recouvre toute la surface extérieure de l'échantillon de la pointe à la base du substrat. Cela se traduit sur la vue en coupe de la figure 15, par un dépôt d'isolant ic représenté par un trait continu autour de la surface de l'échantillon.

On notera qu'un tel dépôt couche mince d'isolant recouvrant de manière homogène toute la surface de l'échantillon ne peut pas être réalisé avec un procédé in situ en MEB-FIB. En effet, si on n'impose pas un gabarit de surface de dépôt, via une fenêtre, dans le MEB-FIB, le dépôt est alors non maîtrisé, inhomogène, avec des protubérances. La forme de pointe serait perdue et l'épaisseur non garantie partout.

L'invention qui vient d'être décrite permet d'obtenir un taux de réussite très amélioré d'analyse complète, en sonde atomique tomographique, d'échantillons de structures aussi bien tridimensionnelles ou bidimensionnelles, élaborées sur substrat de silicium massif ou substrat de silicium sur isolant.

Elle peut être plus généralement appliquée pour l'analyse de structures comportant des interfaces de type conducteur sur isolant ou semi-conducteur sur isolant, par exemple pour l'analyse de structures élaborées pour la photonique.

## Revendications

1. Procédé de préparation d'un échantillon formé en pointe pour une analyse atomique en sonde tomographique d'une structure (ROI) située dans le volume de la pointe, la structure à analyser étant disposée sur un substrat (S) et recouverte d'une couche de protection (cap), le substrat (S) comportant au moins une couche support en matériau conducteur ou semi-conducteur (Bulk-Si) et la structure à analyser (ROI) comprenant au moins une couche conductrice ou semi-conductrice (Iᵣₒᵢ) disposée sur une couche isolante, le procédé étant **caractérisé en ce qu'il** comprend au moins un dépôt en couche mince d'un matériau isolant localisé sur la surface extérieure de l'échantillon, à hauteur de la structure à analyser et s'étendant sur toute la hauteur de ladite couche isolante jusqu'à une région à hauteur du substrat support, formant un lien de matériau isolant reliant mécaniquement le substrat support, la couche isolante et la structure à analyser, ledit matériau isolant déposé en couche mince étant un matériau dont la valeur du champ d'évaporation est égale ou voisine de la moyenne des champs d'évaporation des matériaux constituant la structure à analyser.

2. Procédé selon la revendication 1, **caractérisé en ce que** ledit matériau isolant déposé en couche mince est choisi parmi les matériaux suivants : oxyde de silicium, de zirconium ou de hafnium.

3. Procédé selon la revendication 1, **caractérisé en ce que** la couche support du substrat est en silicium, la couche isolante est en oxyde de silicium et le matériau isolant est un oxyde de silicium.

4. Procédé selon la revendication 3, **caractérisé en ce que** le dépôt en couche mince d'oxyde de silicium est réalisé dans un appareil microélectronique à balayage équipé d'une colonne d'ions focalisés, après une étape d'usinage de l'échantillon en forme de pointe.

5. Procédé selon la revendication 4, **caractérisé en ce que** le dépôt localisé en couche mince d'oxyde de silicium est réalisé par injection de gaz et balayage dans une fenêtre (M1, M2) dont les dimensions sont fonction de la géométrie de la structure à analyser.

6. Procédé selon la revendication 5, **caractérisé en ce qu'**un dépôt localisé en couche mince est réalisé dans une fenêtre de balayage (M1) dont les dimensions sont déterminées pour au moins recouvrir toute la surface d'une face d'extrémité d'une couche (Iᵣₒᵢ) conductrice ou semi-conductrice de la structure à analyser qui affleure en surface de l'échantillon.

7. Procédé selon la revendication 6, **caractérisé en ce qu'**un dépôt localisé en couche mince est réalisé dans une fenêtre de balayage (M2) dont les dimensions sont déterminées pour sensiblement correspondre à celles d'une face latérale longitudinale d'une couche (Iᵣₒᵢ) conductrice ou semi-conductrice de la structure à analyser.

8. Procédé selon la revendication 5, **caractérisé en ce que** le gaz injecté est du tetraethoxysilane.

9. Procédé selon l'une des revendications 5 et 6, **caractérisé en ce que** le dépôt localisé en couche mince d'oxyde de silicium comprend N dépôts d'oxyde de silicium, après rotation de 2π/N de l'échantillon entre deux dépôts successifs.

10. Procédé selon la revendication 9, dans lequel N est égal à 4.

11. Procédé selon la revendication 1, 2 ou 3, **caractérisé en ce que** le dépôt localisé en couche mince de matériau isolant est réalisé en dehors d'un appareil d'usinage en pointe de l'échantillon, et **en ce qu'**il couvre de manière sensiblement uniforme toute la surface de l'échantillon.

12. Procédé selon l'une quelconque des revendications précédentes, **caractérisé en ce que** la couche mince de matériau isolant déposée à une épaisseur de l'ordre de 2 ou 3 nanomètres.

13. Procédé selon l'une des revendications 1 à 12, **caractérisé en ce que** la structure analysée est une structure tridimensionnelle ou une structure bidimensionnelle, formée sur un substrat de silicium massif ou un substrat de silicium sur isolant, la structure bidimensionnelle pouvant être un empilement de couches isolantes et conductrices ou semiconductrices.
